# DEMANDE DE BREVET EUROPEEN

(11) **EP 2 833 364 A2**
(43) Date de publication de la demande: **04.02.2015**
(21) Numéro de dépôt: 14178932.1
(22) Date de dépôt: 29.07.2014
(51) Int. Cl.: G11C 11/16, G11C 14/00

(54) **Cellule mémoire magnetique non volatile à trois electrodes et matrice associée**

(30) Priorité: 30.07.2013 FR 1357536
(71) Demandeur: COMMISSARIAT A L'ENERGIE ATOMIQUE ET AUX ENERGIES ALTERNATIVES, 75015 Paris (FR); CENTRE NATIONAL DE LA RECHERCHE SCIENTIFIQUE, 75794 Paris Cedex 16 (FR)
(72) Inventeur: Di Pendina, Grégory, 38130 Echirolles (FR); Jabeur, Kotb, 69210 L'Arbresle (FR)
(74) Mandataire: Thibon, Laurent

(57) **Abrégé**

L'invention concerne un dispositif mémoire comprenant : une cellule mémoire comprenant au moins un élément mémoire résistif (202) ayant des première, deuxième et troisième bornes (A, B, C), la résistance entre la troisième borne (C) et l'une et/ou l'autre des première et deuxième bornes étant programmable pour avoir l'un d'au moins deux états résistifs (Rₘᵢₙ, Rₘₐₓ) ; et un circuit de commande (204) adapté : pendant une phase d'écriture de l'élément mémoire résistif, à programmer l'état résistif en faisant circuler un courant entre les première et deuxième bornes ; et pendant une phase de lecture de l'élément mémoire résistif, à appliquer une tension entre le troisième et au moins l'une des première et deuxième bornes pour générer, à travers le premier élément mémoire résistif, un courant proportionnel à l'état résistif programmé.

## Description

### DOMAINE

La présente demande concerne le domaine des mémoires non volatiles, et en particulier une cellule mémoire non volatile et un procédé d'écriture et de lecture de données dans une telle cellule.

### EXPOSE DE L'ART ANTERIEUR

Il a été proposé d'utiliser des éléments résistifs programmables dans des cellules mémoire pour assurer une mémorisation de données non volatiles. De tels éléments résistifs sont programmables pour prendre l'un ou l'autre d'une pluralité d'états résistifs différents. L'état résistif programmé est conservé même quand la tension d'alimentation de la cellule est déconnectée, et par conséquent des données peuvent être mémorisées par de tels éléments d'une manière non volatile.

Divers types d'éléments mémoire résistifs ont été proposés, certains d'entre eux pouvant être programmés par le choix du sens du courant que l'on fait passer dans les éléments résistifs. Un exemple d'un tel élément résistif programmable par un courant est un élément STT (Spin Tranfer Torque - couple de transfert de spin), qui est basé sur des jonctions tunnel magnétiques (MTJ).

De tels éléments mémoire résistifs ont généralement deux bornes, et sont programmés en faisant passer un courant dans un sens ou dans un autre entre les deux bornes. Afin de lire la valeur programmée, une tension est appliquée entre les deux bornes, et le niveau de courant résultant est détecté.

Un inconvénient des éléments mémoire résistifs connus à seulement deux bornes est que, en particulier dans le cas où il y a un nombre élevé de tels éléments mémoire groupés, la densité de courant pendant les opérations de lecture peut provoquer des erreurs de commutation d'une ou de plusieurs de ces cellules mémoire, ce qui entraîne des pertes de données.

### Résumé

Un objet de modes de réalisation de la présente invention est de répondre au moins partiellement à un ou plusieurs besoins de l'art antérieur.

Ainsi, selon un aspect, on prévoit un dispositif mémoire comprenant : une cellule mémoire comprenant au moins un élément mémoire résistif ayant des première, deuxième et troisième bornes, la résistance entre la troisième borne et l'une et/ou l'autre des première et deuxième bornes étant programmable pour avoir l'un d'au moins deux états résistifs ; et un circuit de commande adapté : pendant une phase d'écriture de l'élément mémoire résistif, à programmer l'état résistif en faisant circuler un courant entre les première et deuxième bornes ; et pendant une phase de lecture de l'élément mémoire résistif, à appliquer une tension entre la troisième et au moins l'une des première et deuxième bornes pour générer, à travers le premier élément mémoire résistif, un courant proportionnel à l'état résistif programmé.

Selon un mode de réalisation, la circulation d'un courant entre les première et deuxième bornes comprend : faire circuler un courant de la première borne à la deuxième borne pour programmer un premier état résistif de l'élément mémoire résistif ; ou faire circuler un courant de la deuxième borne à la première borne pour programmer un deuxième état résistif de l'élément mémoire résistif.

Selon un mode de réalisation, l'élément mémoire résistif comprend une couche conductrice comprenant les première et deuxième bornes, et un empilement résistif programmable formé sur la couche conductrice et comprenant la troisième borne.

Selon un mode de réalisation, l'élément résistif est de type jonction tunnel magnétique à couple spin-orbite (SOT-MTJ).

Selon un mode de réalisation, le dispositif mémoire comprend un élément mémoire résistif supplémentaire ayant des première, deuxième et troisième bornes, et une résistance entre la troisième borne et l'une et ou l'autre des première et deuxième bornes de l'élément mémoire résistif supplémentaire, cette résistance étant programmable pour avoir l'un d'au moins deux états résistifs, dans lequel les première ou deuxième bornes de l'élément mémoire résistif et de l'élément mémoire résistif supplémentaire sont couplées l'une à l'autre.

Selon un mode de réalisation, les premières ou deuxièmes borne sont couplées l'une à l'autre par un noeud intermédiaire, la cellule mémoire comprenant en outre un transistor couplé entre le noeud intermédiaire et un niveau de tension de lecture, dans lequel, pendant la phase de lecture, le circuit de commande est adapté à activer le transistor pour appliquer une tension entre la troisième borne et au moins l'une des première et deuxième bornes.

Selon un mode de réalisation, le dispositif mémoire comprend en outre une bascule ayant : un premier noeud d'entrée couplé à la troisième borne de l'élément mémoire résistif ; et un deuxième noeud d'entrée couplé à la troisième borne de l'élément mémoire résistif supplémentaire.

Selon un mode de réalisation, la bascule comprend en outre des premier et deuxième inverseurs couplés de façon croisée entre les premier et deuxième noeuds d'entrée.

Selon un mode de réalisation, le premier inverseur comprend un unique transistor, couplé entre le premier noeud d'entrée et une première tension d'alimentation ; le deuxième inverseur comprend un unique transistor, couplé entre le premier noeud d'entrée et la première tension d'alimentation ; et la bascule comprend en outre un troisième transistor couplé entre la première borne d'entrée et une deuxième tension d'alimentation et adapté à avoir une tension de seuil plus petite que l'unique transistor du premier inverseur, et un quatrième transistor couplé entre la deuxième borne d'entrée et la deuxième tension d'alimentation, et adapté à avoir une tension de seuil plus petite que l'unique transistor du deuxième inverseur.

Selon un mode de réalisation, la bascule comprend en outre un cinquième transistor couplé entre le premier noeud d'entrée et une entrée de donnée de la bascule, le cinquième transistor étant commandé par un signal d'horloge.

Selon un mode de réalisation, le dispositif mémoire comprend en outre un sixième transistor couplé entre les premier et deuxième noeuds d'entrée et activé pendant une partie de la phase de lecture.

Selon un mode de réalisation, le dispositif mémoire comprend un réseau de cellules mémoire, le réseau comprenant une pluralité de rangées de cellules mémoire et une pluralité de colonnes de cellules mémoire.

Selon un mode de réalisation, le réseau comprend : des première lignes de rangée/colonne dont chacune est couplée à la première borne d'au moins un élément mémoire résistif de chaque cellule mémoire d'une rangée ou une colonne correspondante du réseau ; des deuxième lignes de rangée/colonne dont chacune est couplée à la deuxième borne dudit au moins un élément mémoire résistif de chaque cellule mémoire d'une rangée ou une colonne correspondante du réseau ; et des troisième lignes de rangée/colonne dont chacune est couplée à la troisième borne dudit au moins un élément mémoire résistif de chaque cellule mémoire d'une rangée ou une colonne correspondante du réseau.

Selon un mode de réalisation, chaque cellule mémoire du réseau comprend en outre un premier transistor couplé entre la première borne d'au moins un élément mémoire résistif et une première ligne de rangée/colonne correspondante, dans lequel le circuit de commande est adapté à activer le premier transistor d'une cellule mémoire à lire pendant la phase d'écriture.

Selon un mode de réalisation, chaque cellule mémoire du réseau comprend en outre un deuxième transistor couplé entre la troisième borne dudit au moins un élément mémoire résistif et une troisième ligne rangée/colonne correspondante, dans lequel le circuit de commande est adapté à activer le deuxième transistor de la cellule mémoire à lire durant la phase de lecture.

Selon un autre aspect, on prévoit un procédé de programmation d'une cellule mémoire comprenant au moins un élément mémoire résistif ayant des première, deuxième et troisième bornes, la résistance entre la troisième borne et une ou plusieurs des première et deuxième bornes étant programmable pour avoir l'un d'au moins deux états résistifs ; et un circuit de commande, le procédé comprenant : pendant une phase d'écriture de l'élément mémoire résistif, la programmation, par le circuit de commande, d'un état résistif en faisant circuler un courant entre les première et deuxième bornes ; et pendant une phase de lecture de l'élément mémoire résistif, l'application, par le circuit de contrôle, d'une tension entre la troisième borne et au moins l'une des première et deuxième bornes pour générer un courant à travers le premier élément mémoire résistif qui est proportionnel à l'état résistif programmé.

Selon un mode de réalisation, la cellule mémoire comprend en outre un élément mémoire résistif supplémentaire, ayant des première, deuxième et troisième bornes, la résistance entre la troisième borne et l'une et/ou l'autre des première ou deuxième bornes de l'élément mémoire résistif supplémentaire étant programmable pour avoir l'un d'au moins deux états résistifs, le procédé comprenant, pendant la phase d'écriture, la programmation de l'état résistif de l'élément mémoire résistif supplémentaire en faisant circuler un courant entre les première et deuxième bornes.

### BREVE DESCRIPTION DES DESSINS

Ces caractéristiques et avantages, ainsi que d'autres, seront exposés en détail dans la description suivante de modes de réalisation particuliers faite à titre illustratif et non limitatif en relation avec les figures jointes parmi lesquelles :
la figure 1 est une vue en perspective d'un élément mémoire résistif selon un exemple de réalisation de la présente description ;
la figure 2A est un schéma illustrant un dispositif mémoire basé sur l'élément mémoire résistif de la figure 1 selon un exemple de réalisation ;
les figures 2B et 2C sont des chronogrammes illustrant des signaux dans le circuit de la figure 2A pendant une opération d'écriture et de lecture ;
la figure 3A illustre un dispositif mémoire selon un autre mode de réalisation de la présente description ;
la figure 3B illustre plus en détail le dispositif mémoire de la figure 3A selon un exemple ;
les figures 4A à 4D sont des chronogrammes illustrant des signaux dans le circuit de la figure 3B pendant des opérations de lecture et d'écriture ;
la figure 5A illustre un réseau de mémoire selon un exemple de réalisation de la présente description; et
la figure 5B illustre plus en détail une cellule mémoire du réseau de mémoire de la figure 5A selon un exemple de réalisation de la présente description.

### DESCRIPTION DETAILLEE

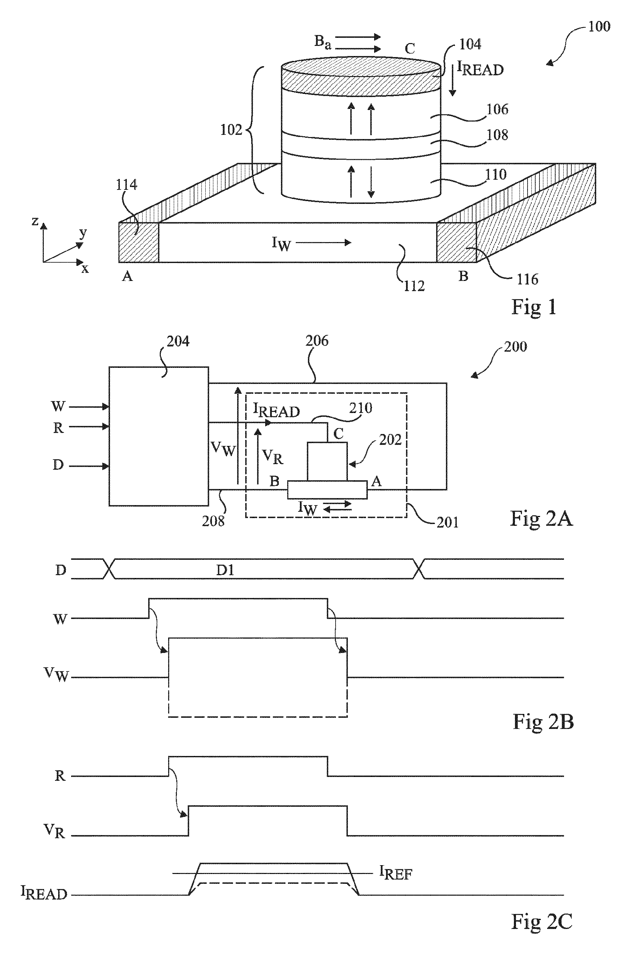

La figure 1 est un vue en perspective d'un élément mémoire résistif 100 selon un exemple de réalisation.

L'élément résistif 100 est, par exemple, une jonction tunnel magnétique à couple spin-orbite (SOT-MTJ). Un tel dispositif est par exemple décrit plus en détail dans la publication intitulée "Voltage and Energy-Delay Performance of Giant Spin Hall Effect Switching for Magnetic Memory and Logic", S. Manipatruni et al., et dans la publication intitulée "Spin-Torque Switching with the Giant Spin Hall Effect of Tantalum", Luqiao Liu et al., DOI: 10.1126/science.1218197 Science 336, 555 (2012), dont le contenu fait partie de la présente description dans les limites autorisées par la loi.

L'élément mémoire résistif 100 comprend trois bornes de connexion, notées A, B et C dans la figure 1. La borne C fait partie d'un empilement résistif 102, qui comprend une électrode 104 formée au-dessus d'une couche de référence nano-magnétique 106. La couche 106 est formée au-dessus d'une couche isolante 108, et la couche 108 est formée au-dessus d'une couche nano-magnétique de mémorisation 110.

La couche de référence 106 correspond à une couche magnétique dans laquelle la direction d'aimantation est fixe. La couche de mémorisation 110 correspond, au contraire, à une couche magnétique dans laquelle la direction d'aimantation peut être commandée.

L'empilement résistif 102 est formé au-dessus d'une couche conductrice 112, qui fournit l'interface pour programmer la direction d'aimantation de la couche de mémorisation 110. La couche conductrice 112 est par exemple en β-tantale (β-Ta), β-tungstène (β-W), et/ou platine (Pt), et comprend par exemple, aux extrémités opposées, une électrode 114 formant une borne A de l'élément 100 et une électrode 116 formant une borne B de l'élément 100. Chacune des électrodes 114, 116 est par exemple en cuivre, ou autre matériau approprié.

Comme le montrent les flèches Bₐ de la figure 1, un champ magnétique statique, par exemple fourni par un aimant permanent ou une couche polarisée, est par exemple présent près de la couche de référence 106. Un tel champ magnétique est par exemple décrit plus en détail dans la publication intitulée "Perpendicular switching of a single ferromagnetic layer induced by in-plane current injection", Ioan mihai Miron et al., Nature 476, 189-193, DOI: 10.1038/nature10309.11, août 2011, dont le contenu fait partie de la présente description dans les limites autorisées par la loi.

Pendant une opération d'écriture, un courant est appliqué de la borne A vers la borne B, ou en sens opposé, afin de programmer la direction d'aimantation de la couche de mémorisation 110. Comme le montrent les flèches x, y, et z en figure 1, la direction du courant d'écriture I_{W} circulant à travers la couche conductrice 112 de la borne A vers la borne B sera appelée direction +x, la direction perpendiculaire à la direction +x dans le plan de la couche de conduction sera appelée direction +y, et la direction ascendante perpendiculaire aux directions +x et +y sera appelée direction +z. Un courant d'écriture positif I_{W} dans la direction +x produira un courant d'injection de spin dont le transport se fait dans la direction +z, et des spins pointant dans la direction +y. Le courant de spin injecté dans la direction +z produira à son tour un couple de spin pour aligner l'aimant dans la direction +y. Un courant d'écriture négatif I_{W} dans la direction -x produira un courant d'injection de spin dont le transport se fait dans la direction -z, et des spins pointant dans la direction -y. Le courant de spin injecté dans la direction -z produira à son tour un couple de spin pour aligner l'aimant dans la direction -y.

Lorsque la direction d'aimantation de la couche de mémorisation 110 est la même que celle de la couche de référence 106, la résistance de l'empilement résistif 102 est par exemple à une valeur relativement basse Rₘᵢₙ. Lorsque la direction de l'aimantation de la couche de mémorisation 110 est opposée à celle de la couche de référence 106, la résistance de l'empilement résistif 102 est par exemple à une valeur relativement haute Rₘₐₓ.

Il apparaîtra à l'homme de l'art que la structure représentée en figure 1 ne constitue qu'un exemple possible d'une structure d'un élément résistif programmable à trois bornes. Dans des variantes de réalisation, une ou plusieurs couches supplémentaires peuvent être ajoutées, et différentes combinaisons de matériaux peuvent être utilisées. En outre, il apparaîtra à l'homme de l'art qu'un noeud de lecture supplémentaire peut être prévu, par exemple sous la couche conductrice 112, ou ailleurs, de telle sorte que les électrodes 114 et 116 soient exclusivement utilisées pour l'écriture.

La figure 2A illustre un dispositif mémoire 200 basé sur un élément mémoire résistif à trois bornes selon un exemple de réalisation.

Le dispositif mémoire 200 comprend une cellule mémoire non volatile 201, qui comprend par exemple un seul élément résistif programmable 202 ayant la même structure que celui de la figure 1. Dans des variantes de réalisation décrites plus en détail par la suite, la cellule mémoire 201 peut comprendre une pluralité d'éléments résistifs programmables.

Le dispositif mémoire 200 comprend en outre un circuit de commande 204, qui reçoit un signal d'écriture W, un signal de lecture R, et un signal de données D. En outre, le circuit 204 a deux lignes de sortie 206 et 208 couplées respectivement aux bornes A et B de l'élément mémoire résistif 202, et a de plus une ligne de sortie 210 couplée à la borne C de l'élément mémoire résistif 202.

Pendant une phase d'écriture de l'élément mémoire résistif 202, le circuit de commande 204 applique par exemple une tension V_{W} entre les lignes de sortie 206 et 208, qui peut être une tension positive ou négative, générant ainsi un courant d'écriture positif ou négatif I_{W} entre les bornes A et B de l'élément mémoire résistif 202.

Un exemple de fonctionnement du dispositif mémoire 200 pendant une opération d'écriture va maintenant être décrit plus en détail en relation avec le chronogramme de la figure 2B.

La figure 2B illustre les signaux D et W, et la tension V_{W}, dans le circuit de la figure 2A pendant une opération d'écriture.

Pendant une opération d'écriture, le signal de données D fournit par exemple un bit de données D1 à mémoriser par l'élément mémoire résistif 202.

Le signal d'écriture W passe par exemple d'un état bas à un état haut pour débuter la phase d'écriture. Ceci déclenche par exemple, peu de temps après, une tension d'écriture V_{W} entre les lignes de sortie 206 et 208 du circuit de commande 204, cette tension étant positive ou négative selon la valeur de la donnée D1. Dans l'exemple de la figure 2B, la tension d'écriture V_{W} est positive, générant un courant positif dans le dispositif 202 de la borne A vers la borne B, et programmant un premier état résistif, qui est par exemple l'état Rₘᵢₙ. Dans une variante illustrée en pointillés en figure 2B, la tension d'écriture V_{W} peut être négative, impliquant qu'une tension positive est appliquée sur la ligne 208, et la masse sur la ligne 206, et qu'un courant circule de la borne B vers la borne A.

De nouveau en relation avec la figure 2A, pendant une phase de lecture, le circuit de commande 204 applique par exemple une tension V_{R} entre les lignes 206 et/ou 208 et la ligne 210. Le courant de lecture généré par cette tension est par exemple dans la direction de la ligne 210 vers la ligne 208/206. A titre de variante, le courant de lecture peut être dans une direction opposée. Dans les deux cas, le circuit de commande 204 comprend par exemple un moyen pour détecter le niveau du courant de lecture I_{READ} sur la ligne 206, 208 ou 210 afin de détecter l'état résistif programmé stocké par l'élément mémoire résistif 202.

Un exemple de fonctionnement du dispositif mémoire 200 pendant une opération de lecture va maintenant être décrit plus en détail en relation avec le chronogramme de la figure 2C.

La figure 2C illustre des signaux du circuit de la figure 2A pendant une opération de lecture selon un exemple de réalisation.

Le signal de lecture R passe par exemple à l'état haut au début de la phase de lecture, déclenchant l'application de la tension de lecture V_{R}, par exemple entre la borne C et l'une et/ou l'autre des bornes A et B de l'élément résistif, afin de générer dans le dispositif un courant d'écriture qui traverse l'empilement résistif 102.

La figure 2C illustre aussi un exemple du courant de lecture I_{READ}, qui augmente jusqu'à un niveau stable peu après que la tension de lecture a été appliquée. Comme cela est représenté en trait plein en figure 2C, le courant de lecture augmente par exemple jusqu'à un niveau haut dans le cas où la résistance a été programmée pour avoir une valeur Rₘᵢₙ, ou à une plus petite valeur comme cela est représenté en pointillés si la résistance a été programmée pour avoir une valeur Rₘₐₓ. Un courant de référence, par exemple à un niveau intermédiaire entre les courants bas et haut de la figure 2C, est par exemple comparé par le circuit de commande 204 au courant de lecture I_{READ} afin de détecter si le courant est supérieur ou inférieur à I_{READ}.

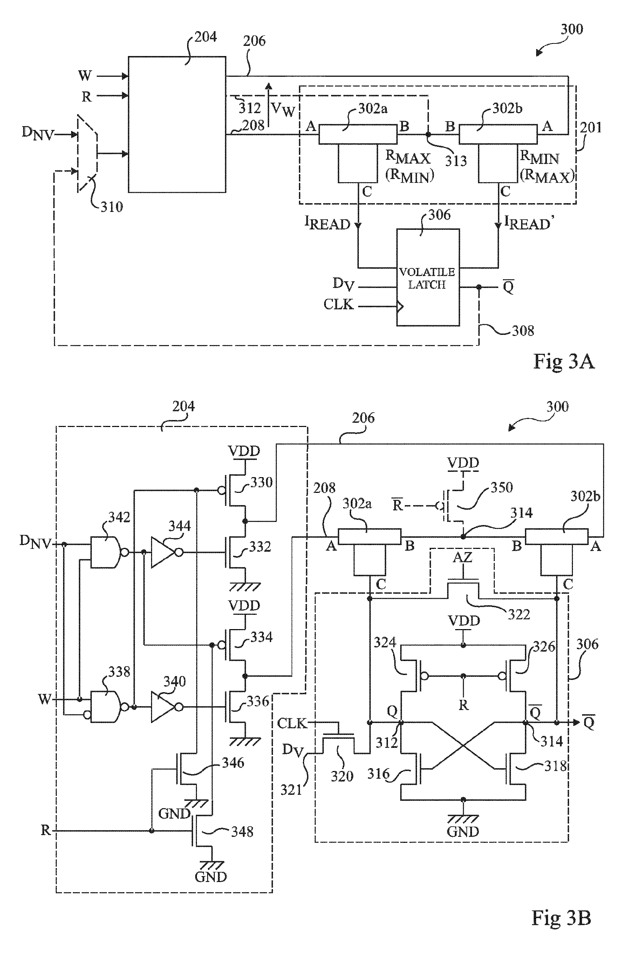

La figure 3A illustre schématiquement un dispositif mémoire 300 selon une variante similaire au dispositif mémoire de la figure 2A, dans laquelle la cellule mémoire 201 comprend une paire d'éléments mémoire résistifs 302a et 302b programmés de façon complémentaire pour mémoriser un bit de données. En outre, dans l'exemple de la figure 3A, le dispositif mémoire 300 forme une bascule à verrouillage de données, comprenant une bascule volatile 306 couplée aux éléments mémoire résistifs 302a, 302b.

Les éléments résistifs 302a, 302b sont couplés en série par leurs bornes A et B entre les lignes de sortie 206, 208 du circuit de commande 204. La borne résistive C de chacun des éléments 302a, 302b est couplée respectivement à un noeud d'entrée de la bascule volatile 306. La bascule volatile 306 reçoit aussi par exemple une donnée volatile D_{V} et un signal d'horloge CLK, et fournit une sortie de données Q̅.

Comme cela est représenté par des pointillés 308 en figure 3A, dans certains modes de réalisation la sortie de données Q̅ est appliquée à l'entrée de données non volatile du circuit de commande 304, par exemple par un multiplexeur 310, de sorte que la donnée mémorisée par la bascule 306 d'une manière volatile puisse être mémorisée d'une manière non volatile par les éléments mémoire résistifs 302a, 302b. Le multiplexeur 310 permet par exemple qu'une sélection soit faite entre la donnée à la sortie de la bascule 306, et la donnée non volatile D_{NV} à écrire dans les éléments mémoire résistifs 302a, 302b pendant une opération d'écriture.

Comme cela est représenté par un trait en pointillés 312 en figure 3A, dans certains modes de réalisation, la tension de lecture V_{R} peut être appliquée à un noeud intermédiaire 313 entre les éléments mémoire résistifs 302a et 302b.

En fonctionnement, la bascule volatile 306 peut fonctionner comme une bascule standard indépendamment des éléments mémoire résistifs 302a, 302b, verrouillant la donnée D_{V} pendant des impulsions à niveau haut du signal d'horloge CLK, et fournissant par exemple l'inverse du signal de données sur sa sortie Q̅. Pendant cette opération, les signaux d'écriture et de lecture W et R sont par exemple bas, ce qui signifie que le circuit de commande 204 n'applique pas de tension haute sur les lignes 206 ou 208.

Lorsqu'une opération d'écriture doit être effectuée, le signal W est activé, et le courant d'écriture est généré par l'intermédiaire des lignes de sortie 206 et 208 du circuit de commande, en passant par les deux éléments mémoire résistifs 302a, 302b. Les éléments résistifs sont par exemple couplés dans des orientations opposées l'un par rapport à l'autre, leurs bornes B étant couplées l'une à l'autre dans l'exemple de la figure 3A. De cette façon, le courant d'écriture programme les éléments résistifs 302a, 302b de manière opposée. Pendant une opération d'écriture, la bascule volatile peut continuer à fonctionner de manière standard en synchronisant le signal de données D_{V}.

Lorsqu'une opération de lecture doit être effectuée, le signal de lecture R est activé, et le circuit de commande 204 active par exemple la tension de lecture V_{R} par exemple en appliquant une tension haute à chacune des lignes de sortie 206 et 208, ou en appliquant une tension haute au noeud intermédiaire 313, afin d'induire des courants de lecture I_{READ} et I_{READ}' à partir de la borne C des éléments 302a, 302b respectivement vers les noeuds d'entrée de la bascule volatile 306. Ces courants de lecture, et en particulier les niveaux relatifs des courants de lecture, programment l'état mémorisé par la bascule volatile 306. Pendant l'opération de lecture, le signal d'horloge CLK se remet à zéro, et la bascule volatile 306 constitue un dispositif de sortie pour le bit de données mémorisé par les éléments mémoire résistifs 302a et 302b.

La figure 3B illustre plus en détail le circuit de la figure 3A, et en particulier le circuit de commande 204 et la bascule volatile 306, selon un exemple de réalisation.

La bascule volatile 306 comprend par exemple des noeuds d'entrée 312, 314 respectivement couplés aux bornes C des dispositifs mémoire résistifs 302a et 302b. Des inverseurs, chacun étant par exemple constitué d'un unique transistor 316, 318, sont couplés de façon croisée entre les noeuds d'entrée 312, 314. Par exemple, le transistor 316 est un transistor MOS à canal N couplé par ses noeuds de courant principaux entre le noeud d'entrée 312 et la masse, et le transistor 318 est un transistor MOS à canal N couplé par ses noeuds de courant principaux entre le noeud d'entrée 314 et la masse. Le noeud de commande du transistor 316 est couplé au noeud d'entrée 314 et le noeud de commande du transistor 318 est couplé au noeud d'entrée 312.

La bascule volatile 306 comprend aussi par exemple un transistor d'entrée 320, par exemple un transistor MOS à canal N, couplé entre le noeud d'entrée 312 et l'entrée de données D_{V}, et commandé par le signal d'horloge CLK. En outre, la bascule 306 comprend par exemple un transistor 322, par exemple un transistor MOS à canal N, couplé entre les noeuds d'entrée 312 et 314, et commandé par un signal de commande AZ. Comme cela sera décrit plus en détail par la suite, un tel transistor, qui peut être omis, peut améliorer la rapidité et la robustesse des opérations de lecture.

Dans certains modes de réalisation, la bascule volatile peut aussi comprendre des transistors 324 et 326, qui sont par exemple des transistors MOS à canal P, et couplent respectivement les noeuds 312 et 314 à la tension d'alimentation VDD. Ces transistors sont par exemple commandés par le signal de lecture R, de telle sorte qu'ils sont désactivés pendant la phase de lecture, mais activés le reste du temps pour maintenir les niveaux logiques mémorisés sur les noeuds d'entrée 312 et 314. A titre de variante, les transistors 324 et 326 peuvent être en permanence désactivés, par exemple en couplant leurs grilles à la tension d'alimentation VDD, et avoir des tensions de seuil plus petites que celles des transistors MOS à canal N 316 et 318, respectivement. Ainsi, dans l'état de non-conduction, le courant de fuite à travers les transistors 324 et 326 est plus grand qu'à travers les transistors 316 ou 318, maintenant ainsi les noeuds correspondants 312 et 314 à un niveau de tension assez haut pour être vu comme étant un niveau logique haut. Autrement dit, le courant de fuite I_{offP} circulant à travers le transistor MOS à canal P 324 ou 326 lorsqu'une tension haute est appliquée à son noeud de grille est plus grand que le courant de fuite I_{offN} circulant à travers le transistor MOS à canal N correspondant 316 ou 318 lorsqu'une tension basse est appliquée à son noeud de grille. La tension de seuil particulière dépendra de la technologie utilisée. Par exemple, les tensions de seuil des transistors MOS à canal P 324, 326 sont choisies pour être dans une plage allant de 0,3 à 0,5 V, tandis que les tensions de seuil des transistors MOS à canal N 316, 318 sont dans une plage allant de 0,4 à 0,6 V. Dans tous les cas, le rapport I_{Offp}/I_{Offn} est sélectionné par exemple pour être supérieur à 25, et de préférence supérieur à 100.

Le bloc de commande 204 comprend par exemple un transistor MOS à canal P 330, couplé par ses noeuds de courant principaux entre la ligne de sortie 206 et la tension d'alimentation VDD, un transistor MOS à canal N 332 couplé par ses noeuds de courant principaux entre la ligne de sortie 206 et la masse. Il comprend aussi par exemple un transistor MOS à canal P 334, couplé par ses noeuds de courant principaux entre la ligne de sortie 208 et la tension d'alimentation VDD, un transistor MOS à canal N 336 couplé par ses noeuds de courant principaux entre la ligne de sortie 208 et la masse. Le noeud de commande du transistor 330 est couplé à la sortie d'une porte NON ET 338, qui reçoit à l'une de ses entrées le signal d'écriture W et à l'autre de ses entrées l'inverse du signal de donnée d'entrée D_{NV}. La sortie de la porte NON ET 338 est aussi couplée par un inverseur 340 au noeud de commande du transistor 336. Le noeud de commande du transistor 334 est couplé à la sortie d'une porte NON ET 342, qui reçoit sur l'une de ses entrées le signal de données D_{NV}, et sur l'autre de ses entrées le signal d'écriture W. La sortie de la porte NON ET 342 est aussi couplée à la grille du transistor 332 par un inverseur 344.

Le circuit de commande 204 comprend aussi par exemple un transistor MOS à canal N 346 couplé entre le noeud de commande du transistor 330 et la masse, et de plus un transistor MOS à canal N 348 couplé entre le noeud de commande du transistor 334 et la masse. Les transistors 346, 348 sont par exemple commandés par le signal de lecture R. A la place des transistors 346, 348, le circuit de commande 204 peut comprendre un transistor MOS à canal P 350, commandé par l'inverse du signal de lecture R, et couplé entre le noeud intermédiaire 313 entre les éléments mémoire résistifs 302a, 302b et la tension d'alimentation VDD.

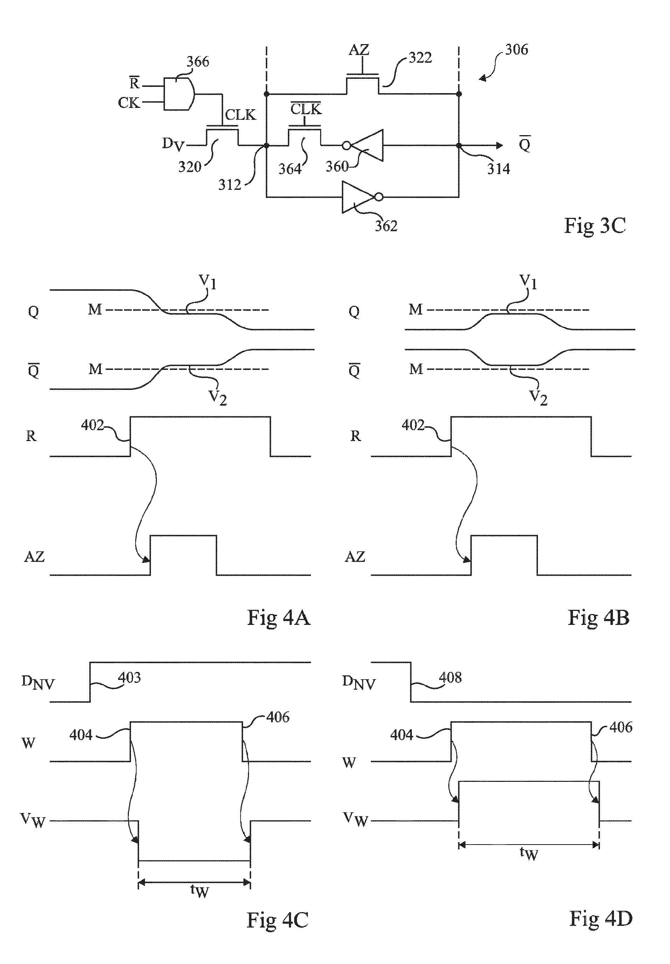

Le fonctionnement du circuit de la figure 3B va maintenant être décrit plus en détail en relation avec les chronogrammes des figures 4A, 4B, 4C et 4D.

Les figures 4A et 4B sont des chronogrammes de signaux dans le dispositif mémoire de la figure 2 pendant une phase de lecture. En particulier, les figures 4A et 4B illustrent les signaux de données Q et Q̅ présents sur les noeuds d'entrée 312, 314, le signal de lecture R, et le signal AZ.

Pendant une phase de lecture, une donnée est transformée d'une représentation d'état résistif programmé des éléments mémoire résistifs 302a, 302b à une représentation de niveaux de tensions sur les noeuds d'entrée 312, 314 de la bascule volatile. Ainsi la phase de lecture implique de définir les niveaux de tension Q et Q̅ sur la base des états résistifs programmés.

Dans les exemples des figures 4A et 4B, on suppose que l'élément mémoire résistif 302a a été programmé pour avoir une résistance haute Rₘₐₓ, et que l'élément mémoire résistif 302b a une résistance basse Rₘᵢₙ. Bien que cela ne soit pas montré en figures 4A et 4B, pendant la phase de lecture, le signal W est par exemple bas.

La figure 4A correspond à un cas dans lequel les tensions Q et Q̅ sont initialement à un état haut et à un état bas respectivement. Le terme "état haut" est utilisé ici pour désigner un niveau de tension proche du niveau de la tension d'alimentation V_{DD}, alors que le terme "état bas" est utilisé ici pour désigner un niveau de tension proche de la masse ou à la masse.

Le signal de lecture R est par exemple initialement bas, de sorte que les transistors 330 et 334 sont non conducteurs. Le signal AZ est par exemple initialement bas, de sorte que le transistor 322 est non-conducteur. Le signal de lecture R, qui est par exemple initialement bas, est activé comme le montre le front montant 402. Ceci active les transistors 346 et 348 du circuit de commande, qui à son tour active les transistors 330 et 334 pour coupler les lignes de sortie 206 et 208 du circuit de commande 204 à la tension d'alimentation. Le signal de lecture déclenche aussi un front montant du signal AZ, et ainsi le transistor 322 de la bascule est activé. Ainsi un courant de lecture I_{READ} sera induit dans la branche gauche de la bascule 306, et circule à travers le transistor 334, l'élément mémoire résistif 302a et le transistor 316, et un courant de lecture I_{READ}' sera induit dans la branche droite de la bascule 306, et circule à travers le transistor 330, l'élément mémoire résistif 302b et le transistor 318.

Cependant, à cause de la différence des résistances programmées des éléments mémoire résistifs 302a, 302b, le courant dans la branche gauche est inférieur au courant dans la branche droite. Ainsi ces courants provoquent par exemple la chute de la tension sur le noeud d'entrée 312 qui s'établit à un niveau V₁ sous un niveau de métastabilité M, et l'élévation de la tension sur le noeud d'entrée 314 à un niveau V₂ au-dessus du niveau de métastabilité M. Le niveau de métastabilité M est un niveau de tension théorique approximativement à mi-chemin entre les états de tension haut et bas, représentant le niveau à partir duquel il y aurait une probabilité égale pour que Q passe à l'état haut ou à l'état bas. Activer le signal AZ pour rendre passant un transistor 322 a comme effet d'accélérer la descente du niveau de tension Q et la montée du niveau de tension Q̅.

Le signal AZ est ensuite amené à l'état bas, de sorte que les niveaux de Q et Q̅ se dirigent vers leur état stable le plus proche, qui dans l'exemple de la figure 4A correspond à l'état bas Q, et l'état haut Q̅. Cependant, il apparaîtra à l'homme de l'art que les niveaux V₁ et V₂, et l'état stable final, dépendront de facteurs tels que les résistances à l'état passant (ON) des transistors 316, 330, 318 et 334. Le signal de lecture R passe par exemple à l'état bas à la fin de la phase de lecture.

La figure 4B correspond à un cas dans lequel les tensions Q et Q̅ sont initialisées, respectivement, à l'état bas et à l'état haut. Par ailleurs, les signaux sont les mêmes que ceux de l'exemple de la figure 4A, et ne seront pas de nouveau décrits en détail.

Les figures 4C et 4D sont des chronogrammes illustrant des exemples des signaux D_{NV}, W et de la tension V_{W} dans le circuit de la figure 3B pendant une phase d'écriture des états résistifs des éléments mémoire résistifs 302a et 302b. Bien que cela ne soit pas montré dans les figures 4C et 4D, pendant la phase d'écriture, le signal de lecture R reste par exemple à l'état bas.

Comme cela est illustré en figure 4C, initialement le signal W est à l'état bas, de sorte que les transistors 330 à 336 du circuit de commande 204 sont tous non conducteurs, et la tension V_{W} est par exemple à 0 V.

Le signal de données D_{NV} de la ligne d'entrée du circuit de commande 204 est par exemple d'abord mis à la valeur qui doit être programmée. Dans l'exemple de la figure 4C, la valeur est un "1" logique et le signal de données D_{NV} débute par exemple à l'état bas, et passe à une valeur haute par un front montant 403.

Le signal d'écriture W passe ensuite à un niveau haut lors d'un front montant 404, déclenchant, un moment plus tard, une tension V_{W} activée dans un sens propre à amener un courant à circuler à travers les éléments mémoire résistifs 302a et 302b dans une direction qui programmera leurs résistances en accord avec la valeur de la donnée logique "1" qui doit être programmée. Dans l'exemple du circuit de commande de la figure 3B, un état haut de la valeur de données D_{NV} correspond à une valeur négative de la tension V_{W}, autrement dit une tension haute sur la ligne 208, et une tension basse sur la ligne 206. Ceci est obtenu par exemple en faisant passer un courant du noeud de mémorisation 206, à travers les éléments résistifs 202 et 204, au noeud de mémorisation 210.

Après que le courant d'écriture a été appliqué suffisamment longtemps pour mettre en oeuvre les états résistifs des éléments mémoire résistifs 302a, 302b, par exemple pendant une durée t_{W} comprise entre 0,1 et 20 ns, le signal W est amené à l'état bas une nouvelle fois, de sorte que la tension d'écriture revient à 0 V.

La figure 4D illustre une variante de phase d'écriture dans laquelle la valeur de la donnée à programmer est une valeur logique "0", et ainsi le signal de données D_{NV} a un front descendant 408. Les autres signaux sont les mêmes que ceux de la figure 4C, excepté qu'une tension positive V_{W} est appliquée plutôt qu'une tension négative.

Les transistors 330 à 334 sont par exemple dimensionnés de sorte que le courant d'écriture qui est généré soit assez fort pour programmer les états résistifs des éléments 302a, 302b. Selon le type et les dimensions des éléments mémoire résistifs 302a, 302b, un tel courant de programmation minimum peut être compris par exemple entre 20 µA et 1,5 mA. Pendant une phase de lecture, le courant de lecture circulera au mieux à travers la moitié de la largeur de la couche conductrice entre les bornes A et B, et donc, il y a un risque relativement bas de programmation indésirable des éléments mémoire résistifs 302a, 302b pendant une opération de lecture.

Il apparaîtra à l'homme de l'art la façon dont le circuit de la figure 3B, dans lequel les transistors 316 et 318 sont des transistors MOS à canal N, peut être adapté à une réalisation à transistors MOS à canal P, en couplant ces transistors à VDD plutôt qu'à la masse, et en remplaçant les transistors 324 et 326 par des transistors MOS à canal N couplés à la masse. Dans un tel cas, pendant l'opération de lecture, les bornes A et/ou B des éléments mémoire résistifs 302a, 302b, sont par exemple couplées à la masse plutôt qu'à la tension d'alimentation VDD.

De nouveau en relation avec la figure 3B, dans certains modes de réalisation, les transistors 316 et 318 peuvent comprendre des noeuds de substrat (non illustrés ici) permettant à leur tension de substrat d'être commandée. Par exemple, le noeud de substrat de chaque transistor 316 et 318 reçoit une tension de substrat V_{BULK}. Pendant un fonctionnement normal de la bascule 306, la tension de substrat V_{BULK} est mise à un niveau, par exemple la masse, de sorte que les tensions de seuil des transistors MOS à canal N 316, 318 sont plus grandes que les tensions de seuil des transistors MOS à canal P 324 et 326. Pendant le mode de lecture, la tension de substrat V_{BULK} est mise à un niveau, par exemple la tension d'alimentation VDD, tel que les tensions de seuil des transistors MOS à canal N 316, 318 diminuent, ce qui amène à une opération de lecture plus rapide. Pendant la phase d'écriture, et au moins pendant une période d'écriture t_{W} de la figure 4C ou 4D, la tension de substrat V_{BULK} est par exemple mise à un niveau inférieur à la masse, par exemple à -VDD, de sorte que la résistance des transistors MOS à canal N 316, 318 et en particulier du transistor MOS à canal N qui est passant, est améliorée, abaissant ainsi toute fuite de courant d'écriture. En effet, de cette façon, plus de courant d'écriture circulera à travers les bornes A et B des éléments résistifs 302a et 302b pendant une opération d'écriture.

La figure 3C illustre la bascule 306 de la figure 3B selon une variante dans laquelle les transistors 316, 318 et 324, 326 sont remplacés par des inverseurs 360 et 362 couplés de façon croisée entre les noeuds d'entrée 312 et 314. La sortie de l'inverseur 360 est par exemple couplée au noeud d'entrée 312 par l'intermédiaire d'un transistor MOS à canal N 364. Le transistor 320 est par exemple commandé par un signal CLK, et le transistor 364 par l'inverse de ce signal. Le signal CLK est fourni par une porte ET 366, qui reçoit par exemple un signal d'horloge CK et l'inverse du signal de lecture R sur ses noeuds d'entrées.

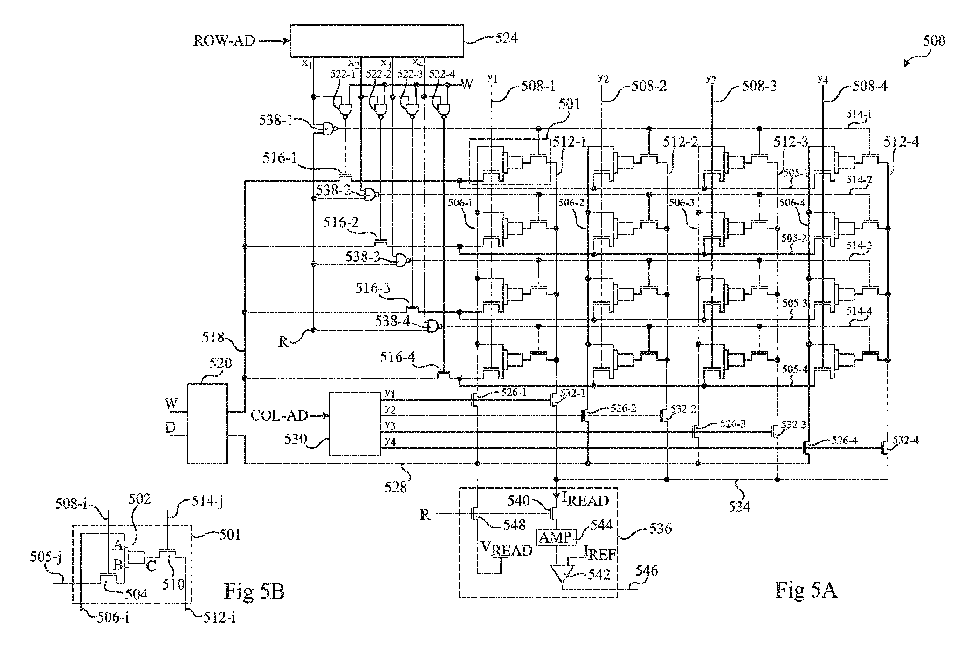

La figure 5A illustre schématiquement un réseau de mémoire 500 selon un exemple d'un mode de réalisation.

Le réseau de mémoire 500 comprend un réseau de cellules mémoire d'un bit 501.

La figure 5B illustre plus en détail l'une des cellules mémoire d'un bit 501, qui comprend par exemple un élément mémoire résistif 502 tel que décrit ici. La cellule mémoire d'un bit 501 est supposée être dans une ième colonne et une jième rangée du réseau, et comprend par exemple un transistor d'écriture 504 ayant l'un de ses noeuds de courant principaux couplé avec une ligne de rangée 505-j associée avec une jième rangée du réseau, et l'autre de ses noeuds de courant principaux couplé avec la borne B de l'élément mémoire résistif 502. La borne A est par exemple couplée à une ligne de colonne 506-i associée à une ième colonne du réseau. La borne C de l'élément résistif 502 est couplée, par l'intermédiaire des noeuds de courant principaux d'un transistor de lecture 510, à une ligne de colonne 512-i associée à la ième colonne du réseau. Le transistor 510 a par exemple son noeud de commande couplé avec une ligne de rangée 514-j associée à la jième rangée du réseau.

En faisant de nouveau référence à la figure 5A, le réseau comprend par exemple quatre rangées et quatre colonnes de cellules mémoire d'un bit , et ainsi il y a quatre lignes de rangée correspondantes 505-1 à 505-4 qui fournissent par exemple un chemin d'écriture pour les cellules mémoire d'un bit , quatre lignes de colonnes correspondantes 506-1 à 506-4 qui correspondent par exemple à des lignes de source, quatre lignes de colonne correspondantes 508-1 à 508-4 qui fournissent par exemple des signaux d'écriture de colonne, quatre lignes de colonne correspondantes 512-1 à 512-4 qui correspondent par exemple à des lignes de bit, et quatre lignes de rangée correspondantes 514-1 à 514-4 qui fournissent par exemple des signaux de lecture de rangée.

Chacune des lignes de rangée 505-1 à 505-4 est couplée par l'intermédiaire d'un transistor correspondant 516-1 à 516-4 à une ligne de sortie 518 d'un bloc d'écriture 520. Par exemple, chacun des transistors 516-1 à 516-4 a son noeud de commande couplé à la sortie d'une porte NON ET correspondante 522-1 à 522-4, chacune d'entre elles recevant un signal de sortie correspondant x₁ à x₄ d'un décodeur de rangée 524 sur l'une de ses entrées, et un signal d'écriture W sur une autre de ses entrées.

Chacune des lignes de colonne 506-1 à 506-4 est couplée par l'intermédiaire d'un transistor correspondant 526-1 à 526-4 à une ligne de sortie 528 du bloc d'écriture 520. Par exemple, chacun des transistors 526-1 à 526-4 est commandé par un signal de sortie correspondant y₁ à y₄ d'un décodeur de colonne 530. En outre, chacune des lignes de colonne 508-1 à 508-4 est par exemple couplée pour recevoir l'un des signaux de sortie y₁ à y₄ correspondant.

Chacune des lignes de colonne 512-1 à 512-4 est couplée par l'intermédiaire d'un transistor correspondant 532-1 à 532-4 à une ligne de sortie 534, qui est à son tour couplée à une entrée d'un bloc de lecture 536. Chacune des lignes de rangée 514-1 à 514-4 est couplée à la sortie d'une porte NON ET correspondante 538-1 à 538-4, dont chacune a l'une de ses entrées couplée à l'un des signaux de sortie correspondant x₁ à x₄ du décodeur de rangée 524, et l'autre de ses entrées couplée pour recevoir un signal de lecture R.

Le bloc de lecture 536 comprend par exemple un transistor 540 couplé entre la ligne 534 et une entrée d'un comparateur 542, par exemple par l'intermédiaire d'un amplificateur 544. L'autre entrée du comparateur 542 reçoit par exemple un courant de référence I_{REF}. Le comparateur 542 fournit un signal de sortie sur la ligne 546. Le bloc de lecture 536 comprend aussi par exemple un transistor 548 couplé entre la ligne 528 et une tension de lecture V_{READ}, et commandé par le signal de lecture R.

Le décodeur de rangée et le décodeur de colonne 524 et 530 reçoivent respectivement par exemple une adresse de rangée ROW_AD et une adresse de colonne COL_AD.

Le bloc d'écriture 520 reçoit par exemple le signal d'écriture W, et un signal de données D représentant une donnée à écrire dans une ou plusieurs des cellules mémoire d'un bit 501.

En fonctionnement, pendant une phase d'écriture, le signal de lecture R est à l'état bas, et ainsi les transistors 540 et 548 du bloc de lecture 536 et le transistor de lecture 510 de chacune des cellules d'un bit 501 sont non conducteurs, de sorte que la borne C de chacun des éléments mémoire résistif est flottante. En se basant sur les signaux d'adresse de rangée et d'adresse de colonne ROW_AD, COL-AD, la cellule mémoire 501 à écrire est sélectionnée en activant l'un des transistors correspondants 516-1 à 516-4, l'un des transistors correspondants 526-1 à 526-4 et les transistors d'écriture 504 d'une colonne correspondant à la cellule d'un bit 501 à écrire. Le signal d'écriture W est aussi activé, et une tension positive ou négative est appliquée entre les lignes de sortie 518 et 528 du bloc d'écriture afin de générer un courant d'écriture dans la direction appropriée en se basant sur le signal de données D. Cette opération est par exemple répétée pour toutes les cellules mémoire d'un bit 501 à écrire.

Pendant une opération de lecture, le signal de lecture R passe à l'état haut, et en se basant sur les signaux d'adresse de rangée et d'adresse de colonne ROW_AD, COL-AD, la cellule mémoire 501 à lire est sélectionnée en activant l'un des transistors correspondants 526-1 à 526-4, et l'un des transistors correspondants 532-1 à 532-6, et les transistors de lecture 510 d'une rangée correspondant à la cellule mémoire d'un bit 501 à lire. La ligne de sortie 528 est aussi couplée par exemple à une tension de lecture V_{READ} en activant le transistor 548 afin de générer un courant I_{READ} à travers la cellule mémoire 501 sélectionnée, qui peut être détecté par le bloc de lecture 536. En fonction du niveau du courant I_{READ} détecté par rapport au courant de référence I_{REF}, l'état résistif programmé de l'élément mémoire résistif lu peut être déterminé, et ainsi le signal à la sortie 546 du bloc de lecture 536 indique la valeur du bit de donnée mémorisée. Cette opération est par exemple répétée pour chaque cellule mémoire 501 à lire.

Bien que les cellules mémoire d'un bit 501 des figures 5A et 5B comprennent chacune un élément mémoire résistif 501, dans une variante de réalisation, il apparaîtra à l'homme de l'art que chaque cellule mémoire d'un bit peut comprendre plus d'un élément résistif, par exemple deux éléments ou plus fonctionnant de manière complémentaire.

En outre, bien que le réseau de la figure 5A comprenne quatre colonnes et quatre rangées, il apparaîtra à l'homme de l'art que, dans une variante de réalisation, le réseau peut comprendre plus ou moins de quatre rangées et/ou plus ou moins de quatre colonnes.

En outre, bien que des exemples spécifiques de lignes de rangées et de colonnes du réseau de mémoire aient été décrits, il apparaîtra à l'homme de l'art qu'une ou plusieurs des lignes de colonnes peuvent être converties en lignes de rangées et vice-versa.

En outre, il apparaîtra à l'homme de l'art que dans certains modes de réalisation, les transistors 516-1 à 516-4, 526-1 à 526-4 et/ou 532-1 à 532-4 peuvent être omis, une ou plusieurs cellules mémoire à écrire, ou une cellule mémoire à lire, étant sélectionnée seulement en activant les transistors d'écriture ou de lecture correspondants 504, 510 de la cellule mémoire. Dans un tel cas, les décodeurs de rangée et de colonne 524, 530 peuvent aussi par exemple être omis, et les transistors d'écriture ou de lecture 504, 510 de chaque cellule mémoire sont par exemple commandés par un signal externe indépendant.

Un avantage des modes de réalisation décrits ici est que la cellule mémoire fournit des données mémorisées à volatilité réduite et amène à améliorer la fiabilité en séparant les chemins d'écriture et de lecture. En effet, la séparation des chemins d'écriture et de lecture entraine une réduction du risque d'endommagement, pendant une opération de lecture, de la barrière mémoire résistive qui mémorise l'état mémoire. Ceci est dû au moins en partie au fait que la cellule mémoire comprend un élément mémoire résistif ayant trois bornes, permettant la programmation d'une cellule mémoire en appliquant un courant entre deux bornes (A et B) sans traverser la barrière tunnel. La lecture est d'autre part effectuée en détectant la valeur de la résistance entre la troisième borne (C) et l'une et/ou l'autre des deux autres bornes (A et/ou B), en détectant le niveau d'un courant.

La durée de rétention d'une donnée dans chaque cellule mémoire est par exemple déterminée par le processus technologique utilisé pour former chaque cellule mémoire, ou en adaptant le dessin de la jonction tunnel magnétique pour avoir la durée de rétention désirée. Dans certains modes de réalisation, le même réseau mémoire peut comprendre des éléments résistifs de différentes tailles et ainsi avoir différentes durées de conservation.

Au vu du mode de réalisation illustratif décrit, des variantes, modifications et améliorations apparaîtront facilement à l'homme de l'art.

Par exemple, il apparaîtra à l'homme de l'art que la tension d'alimentation VDD dans les divers modes de réalisation pourrait être à un niveau quelconque, par exemple entre 1 et 3 V, et plutôt que d'être à 0 V, la masse pourrait également être considérée comme une tension qui peut avoir un niveau quelconque, tel qu'un niveau négatif.

En outre, il apparaîtra à l'homme de l'art que, dans les modes de réalisation décrits ici, tous les transistors MOS à canal N peuvent être remplacés par des transistors MOS à canal P et/ou tous les transistors MOS à canal P peuvent être remplacés par des transistors MOS à canal N. Il apparaîtra à l'homme de l'art la façon dont les circuits peuvent être réalisés en utilisant uniquement des transistors MOS à canal P ou uniquement des transistors MOS à canal N. En outre, alors que des transistors basés sur une technologie MOS ont été décrits ici, dans une variante de réalisation, d'autres technologies de transistors peuvent être utilisées, comme la technologie bipolaire.

En outre, l'homme de l'art notera que les diverses caractéristiques décrites en relation avec les divers modes de réalisation peuvent être combinées, dans des variantes de réalisation, selon des combinaisons quelconques.

## Revendications

1. Dispositif mémoire comprenant un réseau de cellules mémoire associé à un circuit de commande,
dans lequel chaque cellule mémoire comprend au moins un élément mémoire résistif (202, 302a, 302b, 502) ayant des première, deuxième et troisième bornes (A, B, C), la résistance entre la troisième borne (C) et l'une et/ou l'autre des première et deuxième bornes étant programmable pour avoir l'un d'au moins deux états résistifs (Rmin, Rmax) ; et
dans lequel le circuit de commande (204) est adapté :
- pendant une phase d'écriture de l'élément mémoire résistif, à programmer l'état résistif en faisant circuler un courant entre les première et deuxième bornes ; et
- pendant une phase de lecture de l'élément mémoire résistif, à appliquer une tension entre la troisième et au moins l'une des première et deuxième bornes pour générer, à travers le premier élément mémoire résistif, un courant proportionnel à l'état résistif programmé; et
dans lequel le réseau comprend :
- des premières lignes de rangée/colonne (505-1 à 505-4) dont chacune est couplée à la première borne d'au moins un élément mémoire résistif de chaque cellule mémoire d'une rangée ou une colonne correspondante du réseau ;
- des deuxièmes lignes de rangée/colonne (506-1 à 506-4) dont chacune est couplée à la deuxième borne dudit au moins un élément mémoire résistif de chaque cellule mémoire d'une rangée ou une colonne correspondante du réseau ; et
- des troisième lignes de rangée/colonne (512-1 à 512-4) dont chacune est couplée à la troisième borne dudit au moins un élément mémoire résistif de chaque cellule mémoire d'une rangée ou une colonne correspondante du réseau ; et.
dans lequel chaque cellule mémoire du réseau comprend en outre un premier transistor (504) couplé entre la première borne dudit au moins un élément mémoire résistif et une première ligne de rangée/colonne correspondante, dans lequel le circuit de commande est adapté à activer le premier transistor d'une cellule mémoire à lire pendant la phase d'écriture.

2. Dispositif mémoire selon la revendication 1, dans lequel la circulation d'un courant entre les première et deuxième bornes comprend :
faire circuler un courant de la première borne à la deuxième borne pour programmer un premier état résistif de l'élément mémoire résistif ; ou
faire circuler un courant de la deuxième borne à la première borne pour programmer un deuxième état résistif de l'élément mémoire résistif.

3. Dispositif mémoire selon la revendication 1 ou 2, dans lequel l'élément mémoire résistif comprend une couche conductrice (112) comprenant les première et deuxième bornes, et un empilement résistif programmable (102) formé sur la couche conductrice et comprenant la troisième borne.

4. Dispositif mémoire selon l'une quelconque des revendications 1 à 3, dans lequel l'élément résistif est de type jonction tunnel magnétique à couple spin-orbite (SOT-MTJ).

5. Dispositif mémoire selon l'une quelconque des revendications 1 à 4, comprenant un élément mémoire résistif supplémentaire (302b) ayant des première, deuxième et troisième bornes (A, B, C), la résistance entre la troisième borne (C) et l'une et ou l'autre des première et deuxième bornes de l'élément mémoire résistif supplémentaire étant programmable pour avoir l'un d'au moins deux états résistifs (Rₘᵢₙ, Rₘₐₓ), dans lequel les première ou deuxième bornes de l'élément mémoire résistif et de l'élément mémoire résistif supplémentaire sont couplées l'une à l'autre.

6. Dispositif mémoire selon la revendication 5, dans lequel les premières ou deuxièmes bornes sont couplées l'une à l'autre par un noeud intermédiaire (313), la cellule mémoire comprenant en outre un transistor (350) couplé entre le noeud intermédiaire (313) et un niveau de tension de lecture, dans lequel, pendant la phase de lecture, le circuit de commande est adapté à activer le transistor pour appliquer une tension entre la troisième borne et au moins l'une des première et deuxième bornes.

7. Dispositif mémoire selon la revendication 5 ou 6, comprenant en outre une bascule (306) ayant :
un premier noeud d'entrée (312) couplé à la troisième borne (C) de l'élément mémoire résistif ; et
un deuxième noeud d'entrée (314) couplé à la troisième borne (C) de l'élément mémoire résistif supplémentaire.

8. Dispositif mémoire selon la revendication 7, dans lequel la bascule comprend en outre des premier et deuxième inverseurs (316, 318, 360, 362) couplés de façon croisée entre les premier et deuxième noeuds d'entrée.

9. Dispositif mémoire selon la revendication 8, dans lequel :
le premier inverseur comprend un unique transistor (316), couplé entre le premier noeud d'entrée (312) et une première tension d'alimentation (GND, VDD) ;
le deuxième inverseur comprend un unique transistor (318), couplé entre le deuxième noeud d'entrée (314) et la première tension d'alimentation (GND, VDD) ; et
la bascule comprend en outre un troisième transistor (324) couplé entre la première borne d'entrée et une deuxième tension d'alimentation et adapté à avoir une tension de seuil plus petite que l'unique transistor du premier inverseur, et un quatrième transistor (326) couplé entre la deuxième borne d'entrée et la deuxième tension d'alimentation, et adapté à avoir une tension de seuil plus petite que l'unique transistor du deuxième inverseur.

10. Dispositif mémoire selon la revendication 8 ou 9, dans lequel la bascule comprend en outre un cinquième transistor (320) couplé entre le premier noeud d'entrée (312) et une entrée de donnée (321) de la bascule, le cinquième transistor étant commandé par un signal d'horloge (CLK).

11. Dispositif mémoire selon l'une quelconque des revendications 7 à 10, comprenant en outre un sixième transistor (322) couplé entre les premier et deuxième noeuds d'entrée et activé pendant une partie de la phase de lecture.

12. Dispositif mémoire selon la revendication 1, dans lequel chaque cellule mémoire du réseau comprend en outre un deuxième transistor (510) couplé entre la troisième borne dudit au moins un élément mémoire résistif et une troisième ligne rangée/colonne correspondante, dans lequel le circuit de commande est adapté à activer le deuxième transistor de la cellule mémoire à lire durant la phase de lecture.
